# DEMANDE DE BREVET EUROPEEN

(11) **EP 3 425 085 A1**
(43) Date de publication de la demande: **09.01.2019**
(21) Numéro de dépôt: 17180199.6
(22) Date de dépôt: 07.07.2017
(51) Int. Cl.: C23C 14/48, B22F 1/02, C23C 14/22

(54) **PROCEDE DE TRAITEMENT DE SURFACE DE PARTICULES D'UNE POUDRE METALLIQUE ET PARTICULES DE POUDRE METALLIQUE OBTENUES GRACE A CE PROCEDE**

(71) Demandeur: The Swatch Group Research and Development Ltd, 2074 Marin (CH)
(72) Inventeur: Miko, Csilla, 1417 Essertines-sur-Yverdon (CH); Bazin, Jean-Luc, 2512 Tüscherz-Alfermée (CH)
(74) Mandataire: ICB SA

(57) **Abrégé**

L'invention concerne un procédé de traitement de surface d'un matériau métallique à l'état de poudre, ce procédé comprenant l'étape qui consiste à se munir d'une poudre formée d'une pluralité de particules du matériau métallique à traiter, et à soumettre ces particules de poudre métallique à un processus d'implantation ionique en dirigeant vers une surface extérieure de ces particules un faisceau d'ions (14) monochargés ou multichargés produit par une source d'ions monochargés ou multichargés par exemple du type à résonance cyclotron électronique ECR, ces particules présentant une forme générale sphérique avec un rayon (R).

L'invention concerne également un matériau à l'état de poudre formé d'une pluralité de particules ayant une couche extérieure (26) céramique et un coeur (24) métallique, ces particules ayant une forme générale sphérique avec un rayon (R).

## Description

### Domaine technique de l'invention

La présente invention concerne un procédé de traitement de surface de particules d'un matériau métallique à l'état de poudre ainsi que des particules de poudre métallique obtenues par la mise en oeuvre d'un tel procédé. Les particules de poudre métallique obtenues grâce au procédé selon l'invention sont destinées à la fabrication de pièces massives grâce à des procédés de métallurgie des poudres tels que le procédé de moulage par injection, mieux connu sous sa dénomination anglo-saxonne Metal Injection Moulding ou MIM, le pressage ou bien encore la fabrication additive comme l'impression laser tridimensionnelle.

### Arrière-plan technologique de l'invention

Les procédés d'implantation ionique consistent à bombarder la surface d'un objet à traiter par exemple au moyen d'une source d'ions mono- ou multichargés du type à résonance cyclotron électronique. Une telle installation est encore connue sous sa dénomination anglo-saxonne Electron Cyclotron Resonance ou ECR.

Une source d'ions ECR fait usage de la résonance cyclotronique des électrons pour créer un plasma. Un volume de gaz à basse pression est ionisé au moyen de micro-ondes injectées à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules de gaz et provoquer leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

Une source d'ions multichargés du type à résonance cyclotron électronique ECR est schématiquement illustrée sur la figure 1 annexée à la présente demande de brevet. Désignée dans son ensemble par la référence numérique générale 1, une source d'ions multichargés ECR comprend un étage d'injection 2 dans lequel on introduit un volume 4 d'un gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 12a et d'une cathode 12b entre lesquelles est appliquée une haute tension. Un faisceau d'ions multichargés 14 produit en sortie de la source d'ions multichargés ECR 1 vient frapper une surface 16 d'une pièce à traiter 18 et pénètre plus ou moins profondément dans le volume de la pièce à traiter 18.

L'implantation d'ions par bombardement de la surface d'un objet à traiter a de nombreux effets parmi lesquels la modification de la microstructure du matériau dans lequel l'objet à traiter est réalisé, l'amélioration de la résistance à la corrosion, l'amélioration des propriétés tribologiques et, plus généralement, l'amélioration des propriétés mécaniques. Plusieurs travaux ont ainsi mis en évidence l'augmentation de la dureté du cuivre et du bronze par implantation ionique d'azote. Il a également été démontré que l'implantation d'azote ou de néon dans le cuivre permet d'augmenter sa résistance à la fatigue. De même, des travaux ont montré qu'une implantation d'azote, même à faible dose (1.10¹⁵ et 2.10¹⁵ ions.cm⁻²), était suffisante pour modifier de manière significative le module de cisaillement du cuivre.

On comprend donc que l'implantation d'ions par bombardement de la surface d'un objet à traiter présente de grands intérêts tant d'un point de vue scientifique que technique et industriel.

Néanmoins, les études menées jusqu'à ce jour ne se sont intéressées qu'à des objets à traiter massifs. Or, de tels objets massifs sont nécessairement limités par les formes et la géométrie qu'il est possible de leur donner grâce aux techniques d'usinage classiques (perçage, fraisage, alésage etc.).

Il existait donc dans l'état de la technique un besoin pour des objets dont les propriétés mécaniques soient améliorées de manière significative tout en n'opposant quasiment aucune limite quant à la forme que de tels objets pouvaient prendre.

### Résumé de l'invention

La présente invention a pour but de répondre au besoin mentionné ci-dessus ainsi qu'à d'autres encore en proposant un procédé de traitement de surface d'un matériau métallique permettant de réaliser des objets dont les formes géométriques sont pratiquement libres de toute contrainte, tout en présentant des propriétés physiques et chimiques modifiées et améliorées.

A cet effet, la présente invention concerne un procédé de traitement de surface d'un matériau métallique, ce procédé comprenant l'étape qui consiste à se munir d'une poudre formée d'une pluralité de particules d'un matériau métallique, et à diriger vers une surface de ces particules un faisceau d'ions monochargés ou multichargés produit par une source d'ions monochargés ou multichargés, les particules présentant une forme générale sphérique.

Selon des formes préférentielles d'exécution de l'invention :
- la source d'ions mono- ou multichargés est du type à résonance cyclotron électronique ECR ;
- on agite les particules de la poudre métallique durant toute la durée du processus d'implantation ionique ;
- la granulométrie des particules de la poudre métallique utilisée est telle que sensiblement 50% de l'ensemble de ces particules a un diamètre compris entre 1 et 2 micromètres, le diamètre des particules de la poudre métallique utilisée n'excédant pas 50 micromètres ;
- le matériau métallique est un métal précieux choisi parmi l'or et le platine ;
- le matériau métallique est un métal non précieux choisi parmi le magnésium, le titane et l'aluminium ;
- le matériau à ioniser est choisi parmi le carbone, l'azote, l'oxygène et l'argon ;
- les ions monochargés ou multichargés sont accélérés sous une tension comprise entre 15'000 et 35'000 volts ;
- la dose d'ions implantés est comprise entre 1.10¹⁵ et 1.10¹⁷ ions.cm⁻²;
- la profondeur maximale d'implantation des ions est de 150 à 200 nm.

La présente invention concerne également une particule d'une poudre métallique avec une surface céramique et un coeur métallique, et plus particulièrement avec une surface qui correspond à un carbure ou à un nitrure du métal dans lequel sont réalisées les particules de la poudre métallique.

Grâce à ces caractéristiques, la présente invention procure un procédé de traitement d'un matériau métallique à l'état de poudre dans lequel les particules formant cette poudre conservent leur structure métallique d'origine en profondeur, tandis que, depuis la surface et jusqu'à une certaine profondeur, les ions monochargés ou multichargés avec lesquels les particules de poudre métallique sont bombardées viennent combler les défauts des mailles de la structure cristallographique du métal, puis se combinent avec les atomes du matériau métallique pour former une céramique, c'est-à-dire un matériau qui est solide à température ambiante et qui n'est ni organique, ni métallique.

On notera que les particules de poudre métallique, après traitement par implantation ionique, sont prêtes à être utilisées dans des procédés de métallurgie des poudres tels que le procédé de moulage par injection, le pressage ou bien encore la fabrication additive comme l'impression laser tridimensionnelle. Par ailleurs, du fait que la surface des particules de poudre métallique se transforme en céramique, en particulier en carbure et/ou en nitrure du métal qui constitue ces particules, les propriétés mécaniques et physiques, notamment la dureté, la résistance à la corrosion ou bien encore les propriétés tribologiques de ces particules de poudre métallique sont améliorées. L'amélioration des propriétés mécaniques et physiques des particules de poudre métallique est conservée lorsque ces poudres métalliques sont utilisées pour réaliser des pièces massives.

De préférence, les particules formant la poudre métallique sont agitées durant toute la durée du traitement d'implantation ionique afin que ces particules soient exposées aux ions du faisceau d'implantation de manière homogène sur toute leur surface sensiblement sphérique.

On notera que, dans l'état de la technique, l'une des techniques couramment utilisée pour obtenir un matériau de type céramique-métal encore appelé « cermet » consiste à mélanger les poudres métallique et céramique de la manière la plus homogène possible, ce qui permet d'obtenir des particules céramiques revêtues d'une couche métallique (comment arrive-t-on à ce résultat ?). Cette technique pose cependant le problème du contrôle précis de l'épaisseur de la couche métallique ainsi que de la qualité de l'interface entre la couche métallique et le coeur céramique.

### Brève description des figures

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :

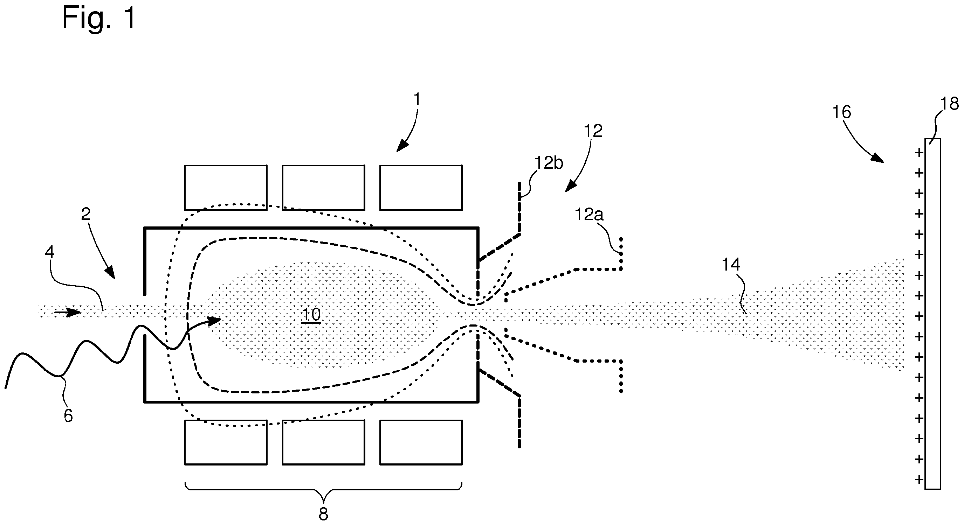

- la figure 1, déjà citée, est une représentation schématique d'une source d'ions multichargés du type à résonance cyclotron électronique ECR;
- la figure 2 est une vue en coupe d'une particule d'or Au dont le rayon est d'environ 1 micromètre et qui a été bombardée au moyen d'un faisceau d'ions carbone C⁺ ;
- la figure 3 est une représentation schématique d'une source d'ions multichargés du type à résonance cyclotron électronique ECR utilisée dans le cadre de la présente invention ;
- la figure 4A illustre le profil d'implantation des ions carbone C⁺ dans une particule de platine Pt dont le rayon est d'environ 1 micromètre ;
- la figure 4B est une vue développée dans le plan d'une particule sensiblement sphérique de platine Pt dont le rayon est approximativement de 1 micromètre et qui montre la trajectoire de pénétration des ions carbone C⁺ dans la particule ;
- la figure 5A illustre le profil d'implantation des ions azote N⁺ dans une particule de platine Pt dont le rayon est d'environ 1 micromètre ;
- la figure 5B est une vue développée dans le plan d'une particule de platine Pt dont le rayon est approximativement de 1 micromètre et qui montre la trajectoire de pénétration des ions azote N⁺ dans la particule ;
- la figure 6A illustre le profil d'implantation des ions carbone C⁺ dans une particule d'or Au dont le rayon est d'environ 1 micromètre ;
- la figure 6B est une vue développée dans le plan d'une particule sensiblement sphérique d'or Au dont le rayon est approximativement de 1 micromètre et qui montre la trajectoire de pénétration des ions carbone C⁺ dans la particule ;
- la figure 7A illustre le profil d'implantation des ions azote N⁺ dans une particule d'or Au dont le rayon est d'environ 1 micromètre, et
- la figure 7B est une vue développée dans le plan d'une particule d'or Au dont le rayon est approximativement de 1 micromètre et qui montre la trajectoire de pénétration des ions azote N⁺ dans la particule.

### Description détaillée d'un mode de réalisation de l'invention

La présente invention procède de l'idée générale inventive qui consiste à soumettre des particules d'une poudre métallique à un processus de traitement d'implantation d'ions dans la surface de ces particules. En bombardant les particules d'une poudre métallique avec des ions mono- ou multichargés fortement accélérés sous des tensions électriques de l'ordre de 15'000 à 35'000 volts, on se rend compte que ces ions commencent par combler les défauts des mailles de la structure cristallographique du métal, puis se combinent avec les atomes du matériau métallique pour former une céramique. Jusqu'à une certaine profondeur depuis la surface des particules de poudre métallique, celles-ci se transforment en céramique, par exemple en carbure ou en nitrure du métal dans lequel sont réalisées les particules. Avantageusement, les propriétés mécaniques et physiques, notamment la dureté, la résistance à la corrosion ou bien encore les propriétés tribologiques de ces particules de poudre métallique avec une couche céramique en surface sont améliorées. L'amélioration des propriétés mécaniques et physiques des particules de poudre métallique dotées d'une couche céramique superficielle est conservée lorsque ces poudres métalliques sont utilisées pour réaliser des pièces massives par les techniques de métallurgie des poudres telles que moulage par injection, pressage, fabrication additive ou autre. Par technique de fabrication additive, on entend une technique qui consiste à fabriquer une pièce massive par ajout de matière. Dans le cas des techniques de fabrication additives, on crée une pièce massive en apportant progressivement un matériau de base brut, alors que dans les techniques de fabrication classiques, on part d'un matériau brut et la pièce finale recherchée est obtenue par enlèvement progressif de matière.

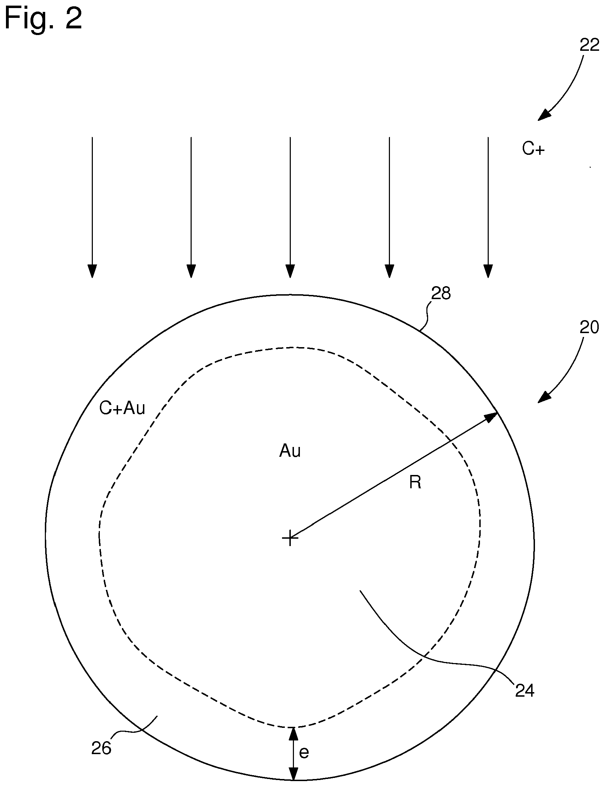

La figure 2 est une vue en coupe d'une particule d'or Au. Désignée dans son ensemble par la référence numérique générale 20, cette particule d'or est de forme sensiblement sphérique avec un rayon R d'environ 1 micromètre. Cette particule d'or 20 a été bombardée au moyen d'un faisceau d'ions carbone C⁺ désigné par la référence numérique 22. Comme il ressort de la figure 2, la particule d'or 20 présente un coeur ou noyau 24 en or pur et une couche extérieure ou écorce 26 principalement constituée de carbure d'or.

L'épaisseur e de cette couche extérieure 26 est de l'ordre du dixième du rayon R de la particule d'or 20, soit environ 100 nanomètres. Cette couche extérieure 26 est en majeure partie constituée de carbure d'or qui est un matériau céramique. Selon l'invention, la concentration en matériau céramique va en croissant depuis la surface extérieure 28 de la particule d'or 20 jusqu'à environ 5% du rayon R de cette particule d'or 20, c'est-à-dire environ 50 nanomètres, puis va en décroissant jusqu'à environ un dixième du rayon R de la particule d'or 20 où elle est sensiblement nulle.

Grâce au procédé selon l'invention, on obtient donc des particules par exemple d'or ou de platine dont le coeur est constitué du métal d'origine, tandis qu'une couche extérieure qui entoure complètement le coeur de ces particules est constitué d'un matériau céramique, par exemple un carbure ou un nitrure, qui résulte de la combinaison des atomes de métal avec les ions avec lesquels les particules sont bombardées.

Conformément à l'invention, on se munit d'une poudre formée d'une pluralité de particules d'un matériau métallique à traiter. Ce matériau métallique peut être non limitativement un métal précieux choisi parmi l'or et le platine. Il peut également s'agir d'un métal non précieux choisi parmi le magnésium, le titane et l'aluminium.

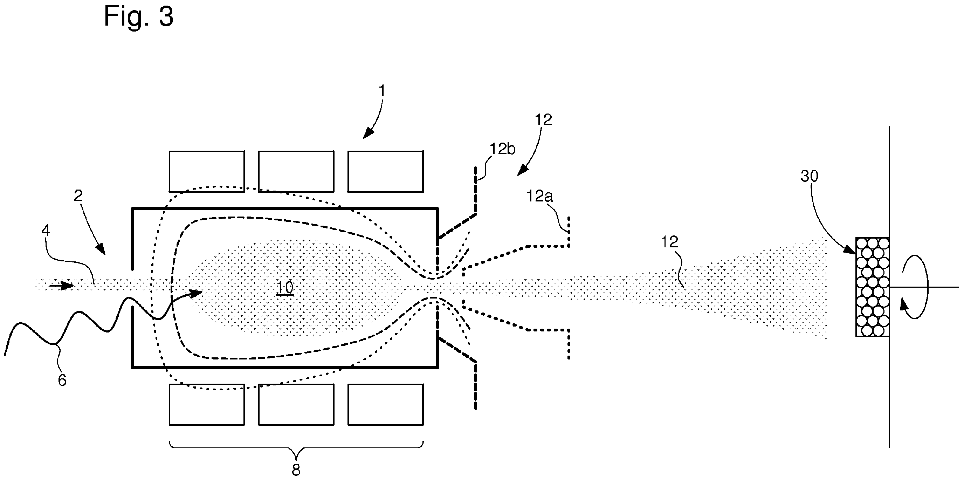

Une fois le métal choisi en fonction des besoins, on soumet les particules de poudre métallique 30 à un processus d'implantation ionique en dirigeant vers une surface extérieure de ces particules un faisceau d'ions 14 monochargés ou multichargés produit par une source d'ions monochargés ou multichargés du type à résonance cyclotron électronique ECR (voir figure 3).

De préférence mais non exclusivement, le matériau à ioniser est choisi parmi le carbone, l'azote, l'oxygène et l'argon, et les ions monochargés ou multichargés sont accélérés sous des tensions comprises entre 15'000 et 35'000 volts. La dose d'ions implantés est comprise entre 1.10¹⁵ et 1.10¹⁷ions.cm⁻².

Les particules de poudre métallique 30 présentent quant à elle une forme générale sphérique avec un rayon R et leur granulométrie est telle qu'environ 50% de l'ensemble de ces particules a un diamètre compris entre 1 et 2 micromètres, le diamètre des particules de poudre métallique 30 n'excédant pas 50 micromètres. De préférence, les particules de poudre métallique 30 sont agitées durant toute la durée du processus d'implantation ionique afin de s'assurer que ces particules soient exposées au faisceau d'ions 14 de manière homogène sur toute leur surface extérieure.

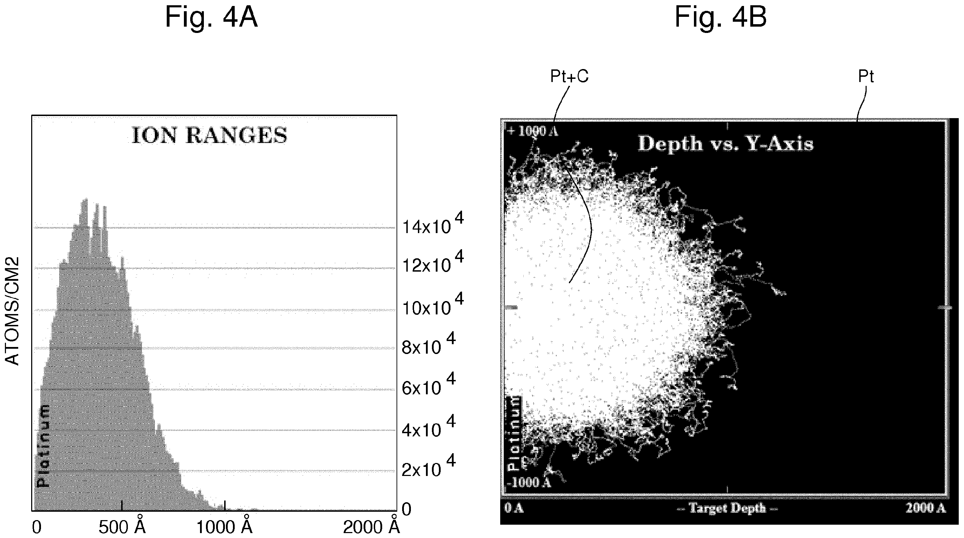

La figure 4A illustre le profil d'implantation des ions carbone C⁺ dans une particule de platine Pt dont le rayon est d'environ 1 micromètre. L'axe des abscisses s'étend le long du rayon R de la particule de platine Pt, avec l'origine de cet axe qui correspond à la surface extérieure de la particule de platine, et la valeur de 2000 Angstrôms qui correspond à environ 20% de la longueur du rayon R de la particule de platine Pt. En ordonnée, on représente le nombre d'ions carbone C⁺ implantés dans la particule de platine Pt à une profondeur donnée. On voit que le nombre d'ions carbone C⁺ implantés dans la particule de platine Pt croît très rapidement depuis la surface extérieure de la particule de platine pour atteindre un maximum excédant 14x10⁴ atomes.cm⁻² à une profondeur correspondant sensiblement à 500 Angstrôms, soit approximativement 5% du rayon R de la particule de platine. Puis le nombre d'ions carbone C⁺ décroît et tend vers zéro à environ 1000 Angstrôms de profondeur, soit approximativement 10% du rayon R de la particule de platine Pt.

La figure 4B est une vue développée dans le plan d'une particule sensiblement sphérique de platine Pt dont le rayon est approximativement de 1 micromètres et qui montre la trajectoire libre moyenne des ions carbone individuels C⁺, C⁺⁺ etc. lorsqu'ils pénètrent dans une particule de platine Pt. Cette figure 4B a été établie pour une densité de l'ordre de 14x10⁴ atomes.cm⁻². En abscisse de la figure 4B est représentée la profondeur de la particule de platine Pt entre la surface (0 Angstrôms) et 2000 Angstrôms. En ordonnée de la figure 4B est représenté le diamètre du faisceau d'ions carbone C⁺. Le centre du faisceau d'ions carbone C⁺ se trouve à mi-hauteur sur l'axe des ordonnées, entre les valeurs -1000 Angstrôms et +1000 Angströms. On voit donc sur cette figure 4B que le diamètre approximatif du faisceau d'ions carbone C⁺ est de l'ordre de 150 nanomètres et que la profondeur de pénétration des ions carbone C⁺ dans la particule de platine Pt n'excède guère plus de 100 nanomètres.

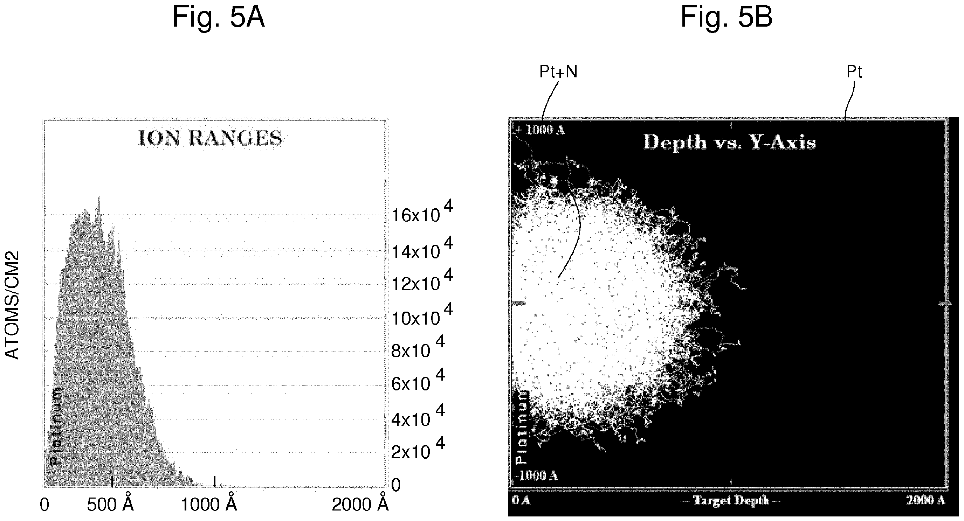

La figure 5A illustre le profil d'implantation des ions azote N⁺ dans une particule de platine Pt dont le rayon R est d'environ 1 micromètre. L'axe des abscisses s'étend le long du rayon R de la particule de platine Pt, avec l'origine de cet axe qui correspond à la surface extérieure de la particule de platine Pt et la valeur de 2000 Angstrôms qui correspond à environ 20% de la longueur du rayon R de la particule de platine Pt. En ordonnée, on représente le nombre d'ions azotes N⁺ implantés dans la particule de platine Pt à une profondeur donnée. On voit que le nombre d'ions azotes N⁺ implantés dans la particule de platine Pt croît très rapidement depuis la surface extérieure de la particule de platine Pt pour atteindre un maximum excédant 16x10⁴ atomes.cm⁻² à une profondeur correspondant sensiblement à 500 Angstrôms, soit approximativement 5% du rayon R de la particule de platine Pt. Puis le nombre d'ions azotes N⁺ décroît et tend vers zéro à une profondeur d'environ 1000 Angstrôms depuis la surface extérieure de la particule de platine Pt, soit approximativement 10% du rayon R de cette particule de platine Pt.

En comparant les figures 4A et 5A, on remarque que les ions azotes N⁺ pénètrent moins profondément dans la maille cristallographique de la particule de platine Pt que les ions carbone C⁺.

La figure 5B est une vue développée dans le plan d'une particule sensiblement sphérique de platine Pt dont le rayon est approximativement de 1 micromètres et qui montre la trajectoire libre moyenne des ions azote individuels N⁺, N⁺⁺ etc. lorsqu'ils pénètrent dans une particule de platine Pt. Cette figure 5B a été établie pour une densité de l'ordre de 16x10⁴ atomes.cm⁻². En abscisse de la figure 4B est représentée la profondeur de la particule de platine Pt entre la surface (0 Angstrôms) et 2000 Angstrôms. En ordonnée de la figure 4B est représenté le diamètre du faisceau d'ions azote N⁺. Le centre du faisceau d'ions N⁺ se trouve à mi-hauteur sur l'axe des ordonnées, entre les valeurs -1000 Angstrôms et +1000 Angströms. On voit donc sur cette figure 5B que le diamètre approximatif du faisceau d'ions N⁺ est de l'ordre de 150 nanomètres et que la profondeur de pénétration des ions N⁺ dans la particule de platine Pt est légèrement inférieure à 100 nanomètres. On constate donc que les ions N⁺ pénètrent moins profondément dans les particules de platine que les ions C⁺.

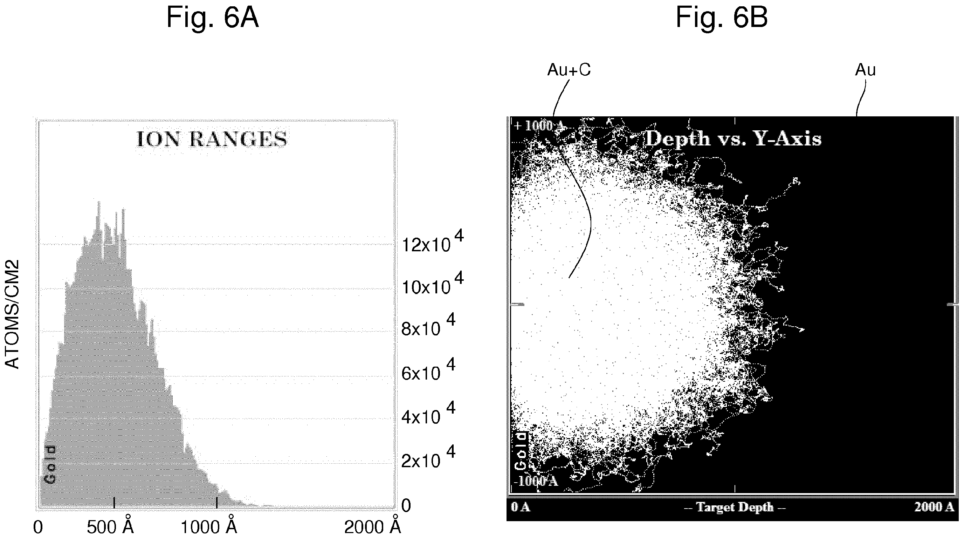

La figure 6A illustre le profil d'implantation des ions carbone C⁺ dans une particule d'or Au dont le rayon R est d'environ 1 micromètre. L'axe des abscisses s'étend le long d'un rayon R de la particule d'or Au, avec l'origine de cet axe qui correspond à la surface extérieure de la particule d'or Au et la valeur de 2000 Angstrôms qui correspond à environ 20% du rayon R de la particule d'or Au. En ordonnée, on représente le nombre d'ions carbone C⁺ implantés dans la particule d'or Au à une profondeur donnée. On voit que le nombre d'ions carbone C⁺ implantés dans la particule d'or Au croît très rapidement depuis la surface extérieure de la particule d'or Au pour atteindre un maximum excédant 12x10⁴ atomes.cm⁻² à une profondeur de 500 Angstrôms, soit approximativement 5% du rayon R de la particule d'or Au. Puis le nombre d'ions décroît et tend vers zéro à environ 1000 nm sous la surface extérieure de la particule d'or Au, soit environ 10% de la longueur du rayon R de la particule.

La figure 6B est une vue développée dans le plan d'une particule sensiblement sphérique d'or Au dont le rayon est approximativement de 1 micromètres et qui montre la trajectoire libre moyenne des ions carbone individuels C⁺, C⁺⁺ etc. lorsqu'ils pénètrent dans une particule d'or Au.

Cette figure 6B a été établie pour une densité d'ions de l'ordre de 12x10⁴ atomes.cm⁻². En abscisse de la figure 6B est représentée la profondeur de la particule d'or Au entre la surface (0 Angstrôms) et 2000 Angstrôms. En ordonnée de la figure 6B est représenté le diamètre du faisceau d'ions carbone C⁺. Le centre du faisceau d'ions C⁺ se trouve à mi-hauteur sur l'axe des ordonnées, entre les valeurs -1000 Angstrôms et +1000 Angströms. On voit donc sur cette figure 6B que le diamètre approximatif du faisceau d'ions C⁺ est de l'ordre de 150 nanomètres et que la profondeur de pénétration des ions C⁺ dans la particule d'or Au excède légèrement 100 nanomètres.

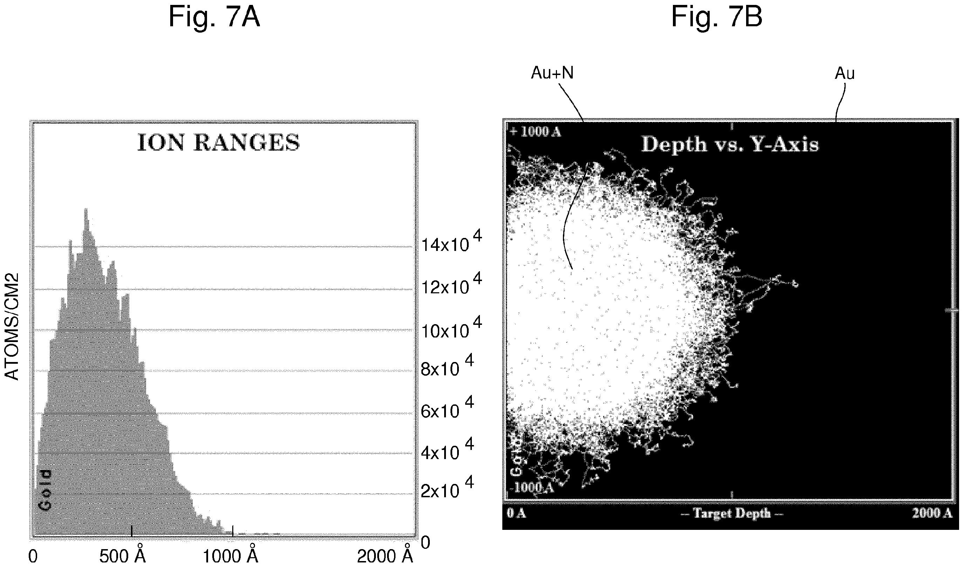

La figure 7A illustre le profil d'implantation des ions azote N⁺ dans une particule d'or Au dont le rayon est d'environ 1 micromètre. L'axe des abscisses s'étend le long d'un rayon R de la particule d'or Au, avec l'origine de cet axe qui correspond à la surface extérieure de la particule d'or Au et la valeur de 2000 Angstrôms qui correspond à environ 20% du rayon R de la particule d'or Au. En ordonnée, on représente le nombre d'ions azotes N⁺ implantés dans la particule d'or Au à une profondeur donnée. On voit que le nombre d'ions azotes N⁺ implantés dans la particule d'or Au croît très rapidement depuis la surface extérieure de la particule d'or Au pour atteindre un maximum excédant 14x10⁴ atomes.cm⁻² à une profondeur de 500 Angstrôms, soit approximativement 5% de la longueur du rayon R de la particule d'or Au. Puis le nombre d'ions azotes N⁺ décroît et tend vers zéro à environ 1000 nm sous la surface extérieure de la particule d'or Au, soit environ 10% de la longueur du rayon R de la particule.

La figure 7B est une vue développée dans le plan d'une particule sensiblement sphérique d'or Au dont le rayon est approximativement de 1 micromètres et qui montre la trajectoire libre moyenne des ions azote individuels N⁺, N⁺⁺ etc. lorsqu'ils pénètrent dans une particule d'or Au. Cette figure 7B a été établie pour une densité d'ions de l'ordre de 14x10⁴ atomes.cm⁻². En abscisse de la figure 7B est représentée la profondeur de la particule d'or Au entre la surface (0 Angstrôms) et 2000 Angstrôms. En ordonnée de la figure 7B est représenté le diamètre du faisceau d'ions carbone N⁺. Le centre du faisceau d'ions azote N⁺ se trouve à mi-hauteur sur l'axe des ordonnées, entre les valeurs -1000 Angstrôms et +1000 Angströms. On voit donc sur cette figure 7B que le diamètre approximatif du faisceau d'ions azote N⁺ est de l'ordre de 150 nanomètres et que la profondeur de pénétration des ions N⁺ dans la particule de platine Pt est de l'ordre de 100 nanomètres. On constate donc que les ions azote N⁺ pénètrent moins profondément dans les particules d'or Au que les ions C⁺.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. En particulier, on comprendra que le processus d'implantation ionique du type à résonance cyclotron électronique ECR est indiqué à titre d'exemple préféré mais nullement limitatif, et que d'autres processus de génération d'un plasma chaud par exemple par induction ou à l'aide d'un champ magnétique intense produit par un générateur de micro-ondes peuvent être envisagés. On notera également que des mesures supplémentaires effectuées par microscopie électronique en transmission sur des particules de saphir de diamètre moyen de 2.0 micromètres implantées par azote confirment que les particules de saphir, après implantation ionique, présentent une écorce céramique d'une épaisseur de l'ordre de 150 à 200 nanomètres. On notera également que le rapport entre le volume des particules qui est irradié et le volume total des particules est de l'ordre de 14%. Du point de vue de la Demanderesse, la poudre obtenue grâce au procédé d'implantation ionique selon l'invention n'est pas véritablement un matériau composite. En effet, au sens où on l'entend habituellement, un matériau composite résulte de la combinaison de deux matériaux distincts, à savoir une matrice et un renfort. Dans le cas présent, on n'a affaire qu'à un matériau unique dans lequel un bombardement ionique provoque une modification de la structure chimique en surface. On pourra donc préférentiellement parler de matériau hétérogène.

### Nomenclature

- 1.: Source d'ions multichargés ECR
- 2.: Etage d'injection
- 4.: Volume d'un gaz à ioniser
- 6.: Onde hyperfréquence
- 8.: Etage de confinement magnétique
- 10.: Plasma
- 12.: Etage d'extraction
- 12a.: Anode
- 12b.: Cathode
- 14.: Faisceau d'ions multichargés
- 16.: Surface
- 18.: Pièce à traiter
- 20.: Particule d'or Au
- R.: Rayon
- 22.: Faisceau d'ions carbone C⁺
- 24.: Coeur ou noyau
- 26.: Couche extérieure ou écorce
- e.: Epaisseur
- 28.: Surface extérieure
- 30.: Particules de poudre métallique

## Revendications

1. Procédé de traitement de surface d'un matériau métallique à l'état de poudre, ce procédé comprenant l'étape qui consiste à se munir d'une poudre (30) formée d'une pluralité de particules du matériau métallique à traiter, et à soumettre ces particules de poudre métallique (30) à un processus d'implantation ionique en dirigeant vers une surface extérieure de ces particules un faisceau d'ions (14) monochargés ou multichargés produit par une source d'ions monochargés ou multichargés, ces particules présentant une forme générale sphérique avec un rayon (R).

2. Procédé selon la revendication 1, **caractérisé en ce que** l'on agite les particules de la poudre métallique (30) durant toute la durée du processus d'implantation ionique.

3. Procédé selon l'une des revendications 1 ou 2, **caractérisé en ce que** la granulométrie des particules de la poudre métallique (30) utilisée est telle que sensiblement 50% de l'ensemble de ces particules a un diamètre compris entre 1 et 2 micromètres, le diamètre des particules de la poudre métallique (30) n'excédant pas 50 micromètres.

4. Procédé selon l'une des revendications 1 à 3, **caractérisé en ce que** le matériau métallique est un métal précieux choisi parmi l'or et le platine.

5. Procédé selon l'une des revendications 1 à 3, **caractérisé en ce que** le matériau métallique est un métal non précieux choisi parmi le magnésium, le titane et l'aluminium.

6. Procédé selon l'une des revendications 1 à 5, **caractérisé en ce que** le matériau à ioniser est choisi parmi le carbone, l'azote, l'oxygène et l'argon.

7. Procédé selon la revendication 6, **caractérisé en ce que** le processus d'implantation ionique est du type à résonance cyclotron électronique ECR.

8. Procédé selon la revendication 7, **caractérisé en ce que** les ions monochargés ou multichargés sont accélérés sous une tension comprise entre 15'000 et 35'000 volts.

9. Procédé selon la revendication 8, **caractérisé en ce que** la dose d'ions implantés est comprise entre 1.10¹⁵ et 1.10¹⁷ions.cm⁻².

10. Procédé selon l'une des revendications 8 ou 9, **caractérisé en ce que** les ions pénètrent dans les particules formant la poudre de matériau métallique jusqu'à une profondeur correspondant à environ 10% du rayon (R) de ces particules.

11. Matériau à l'état de poudre formé d'une pluralité de particules ayant une couche extérieure (26) céramique et un coeur (24) métallique, ces particules ayant une forme générale sphérique avec un rayon (R).

12. Matériau selon la revendication 11, **caractérisé en ce que** la surface céramique correspond à un carbure ou à un nitrure du métal dans lequel sont réalisées les particules de la poudre métallique.

13. Matériau selon l'une des revendications 11 ou 12, **caractérisé en ce qu'**environ 50% des particules ont un diamètre compris entre 1 et 2 micromètres, le diamètre des particules n'excédant pas 50 micromètres.

14. Matériau selon l'une des revendications 11 à 13, **caractérisé en ce que** le matériau métallique dans lequel sont réalisées les particules de la poudre métallique (30) est un métal précieux choisi parmi l'or et le platine.

15. Matériau selon l'une des revendications 11 à 13, **caractérisé en ce que** le matériau métallique dans lequel sont réalisées les particules de la poudre métallique (30) est un métal non précieux choisi parmi le magnésium, le titane et l'aluminium.

16. Matériau selon l'une des revendications 11 à 15, **caractérisé en ce que** la concentration en matériau céramique va en croissant depuis la surface extérieure jusqu'à environ 5% de la longueur du rayon (R) des particules, puis va en décroissant jusqu'à environ 10% de la longueur du rayon (R) des particules où elle est sensiblement nulle.
